(19) **Europäisches Patentamt**

**European Patent Office**

**Office européen des brevets**

(11) Veröffentlichungsnummer: **0 368 087**

**A2**

(12) **EUROPÄISCHE PATENTANMELDUNG**

(21) Anmeldenummer: **89119915.0**

(22) Anmeldetag: **26.10.89**

(51) Int. Cl.⁵: **H01S 3/19**

(30) Priorität: **09.11.88 DE 3838016**

(43) Veröffentlichungstag der Anmeldung:
**16.05.90 Patentblatt 90/20**

(84) Benannte Vertragsstaaten:
**DE FR GB**

(71) Anmelder: **Siemens Aktiengesellschaft**
**Wittelsbacherplatz 2**
**D-8000 München 2(DE)**

(72) Erfinder: **Gessner, Roland**
**Rosenweg 54a**
**D-8192 Geretsried(DE)**
Erfinder: **Beschorner, Margit**
**Am Bergerfeld 37**
**D-8019 Assling(DE)**
Erfinder: **Druminski, Manfred, Dr.**
**Robert-Stolzstrasse 20**
**D-8011 Vaterstetten(DE)**

(54) **Halbleiterlaser im System GaAlInAs.**

(57) Halbleiterlaser auf InP-Substrat (1) mit einer ersten Confinement-Schicht (2) und einer zweiten Confinement-Schicht (4) aus $(Ga_{0,17}Al_{0,83})_{0,48}In_{0,52}As$ und einer aktiven Schicht (3) in Quantum-well-Struktur mit strahlungserzeugenden QW-Schichten (5) aus $Ga_{1-y}In_yAs$.

EP 0 368 087 A2

## Halbleiterlaser im System GaAlInAs

Die Herstellung von Halbleiterlasern für Wellenlängen zwischen 1,3 und 1,55 $\mu$m auf der Basis des Materialsystems InGaAs/InGaAlAs/InAlAs auf InP-Substrat ist in der Arbeit von Y. Kawamura in Electronics Letters 20, 1984, Seiten 459-460 beschrieben. Bei diesem Aufbau sind auf einem Indiumphosphidsubstrat je eine Indiumphosphidschicht und eine InAlAs-Schicht als Confinement-Schichten aufgewachsen. Dazwischen befindet sich eine Multi-quantum-well-Struktur aus einer Abfolge von InGaAs-und InGaAlAs-Schichten. Dieser Aufbau ist mittels MBE hergestellt.

Eine phosphorfreie Multi-quantum-well-Struktur ist in der Arbeit von Y. Matsushima Electronics Letters 23, 1987, Seite 1271 bis 1273 angegeben. Dabei ist mittels MBE eine Schichtfolge aus abwechselnd $Ga_{0,47}In_{0,53}As/Al_{048}In_{0,52}As$ aufgewachsen.

In der Arbeit von J.I. Davies, Electronics Letters 24, 1988, Seiten 732 bis 733 ist ein Aufbau mit einer aktiven Schicht aus AlGaInAs und Confinement-Schichten aus InP angegeben. Dieser Aufbau ist mit MOVPE hergestellt.

In der Druckschrift von K. Alavi, Applied Physics Letters 42, 1983, Seiten 254 bis 256 ist ein Aufbau beschrieben, bei dem die aktive Schicht GaAlInAs-Material ist und die Confinement-Schichten aus AlInAs sind. Dieser Aufbau ist mittels MBE hergestellt.

W.T. Tsang beschreibt in Journal of Applied Physics 52, 1981, Seiten 3861 bis 3864 einen Aufbau, bei dem auf einem Indiumphosphidsubstrat eine Schichtfolge AlInAs/GaInAs/AlInAs/GaInAs aufgewachsen ist. Die Herstellung dieser Schichtfolge erfolgt mittels MBE.

W.T. Tsang gibt in Applied Physics Letters 42, 1981, Seite 922 bis 924 einen Aufbau mit einem Indiumphosphid-Substrat und einer aktiven Schicht aus GaAlInAs zwischen Indiumphosphid-Confinement-Schichten an. Dieser Aufbau wird mittels MBE hergestellt.

Bei T. Miyazawa in Japanese Journal of Applied Physics 27, L1731 bis L1733, 1988 ist ein Aufbau beschrieben, bei dem auf einem Indiumphosphidsubstrat eine Multi-quantum-well-Struktur aus InGaAs/InAlAs-Material aufgewachsen wurde. Auch hier ist beim Herstellungsverfahren MBE angewendet worden.

In der US-4 430 740 von T.L. Nuyen ist ein Halbleiterlaser auf InP beschrieben, bei dem eine aktive Schicht aus $(Ga_x\text{-}Al_{l\text{-}x})_{0,47}In_{0,53}As$ zwischen Confinementschichten aus $Ga_zAl_{l\text{-}z}AS_ySb_{l\text{-}y}$ auf einem Substrat aus InP aufgewachsen ist.

In der US-4 599 728 von K. Alavi ist ein Halbleiterlaser mit Quantum-well-Struktur beschrieben, bei dem aktive Schichten aus $Ga_{0,47}In_{0,53}$ As durch Zwischenschichten aus $Al_{0,48}In_{0,52}As$ unterbrochen und die Confinementschichten aus $Al_{0,48}In_{0,52}As$ sind. Als weitere Materialien sind für die aktiven Schichten GaInAs und GaAsSb und für die Zwischenschichten AlInAs, InP und AlAsSb genannt.

Aufgabe der vorliegenden Erfindung ist es, einen Schichtaufbau far eine Halbleiterdiode anzugeben, die besonders einfach herstellbar ist. Dabei soll gleichzeitig eine günstige Strahlungsausbeute erreicht werden.

Diese Aufgabe wird gelöst mit einer Halbleiterdiode mit den Merkmalen des Anspruchs 1.

Weitere Ausgestaltungen ergeben sich aus den Unteransprüchen.

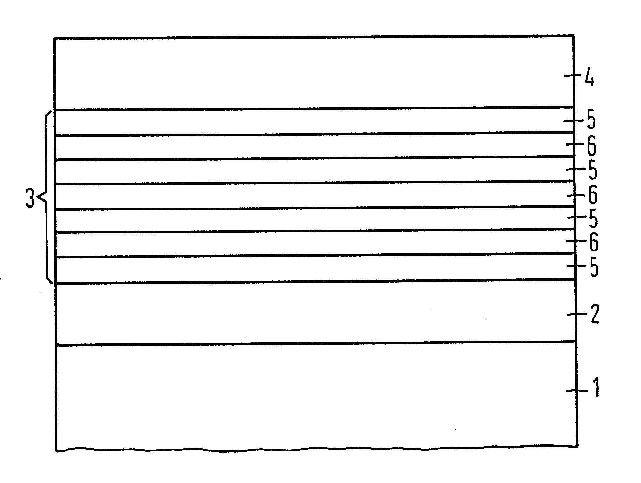

Die Figur zeigt den erfindungsgemäßen Schichtaufbau.

Auf dem Substrat 1 aus InP ist die erste Confinement-Schicht 2 aufgewachsen. Darauf befindet sich die aktive Schicht 3, die im Falle einer Quantum-well-struktur aus einer Aufeinanderfolge von dünnen QW-Schichten 5 zur Strahlungserzeugung und diese QW-Schichten 5 trennende Zwischenschichten 6 besteht, und einer zweiten Confinement-Schicht 4. Die für die Strahlungserzeugung vorgesehenen Schichten, d.h. die aktive Schicht 3 bzw. insbesondere die QW-Schichten 5, bestehen aus $(Ga_{l\text{-}x}Al_x)_{l\text{-}y}In_yAs$. Der durch x gegebene Anteil an Aluminium ist für die Wellenlänge der erzeugten Strahlung maßgeblich. Im Falle einer Quantum-well-Struktur kann x gleich 0 sein, da die Wellenlänge der Strahlung bei dem Quantum-well auch durch die Dicke der betreffenden QW-Schichten 5 einstellbar ist.

Wesentlich bei dem erfindungsgemäßen Aufbau ist, daß sämtliche auf das Substrat 1 aufgewachsenen Schichten kein Phosphor enthalten. Die erste Confinement-Schicht 2 und die zweite Confinement-Schicht 4 sind $(Ga_{l\text{-}x}Al_x)_{l\text{-}y}In_yAs$, wobei sich der durch x gegebene Aluminiumanteil von dem Aluminiumanteil der aktiven Schicht 3 unterscheidet. Die Zwischenschichten 6 bei der Quantum-well-Struktur sind ebenfalls $(Ga_{l\text{-}x}Al_x)_{l\text{-}y}In_yAs$, wobei die Werte von x und y nicht dieselben zu sein brauchen wie bei den Confinement-Schichten.

Der Energiebandabstand des $(Ga_{l\text{-}x}Al_x)_{l\text{-}y}In_yAs$ ist eine streng monoton steigende lineare Funktion des Aluminiumanteiles x bei konstantem In. Für GaInAs erhält man einen Energiebandabstand von 0,744 eV; für AlInAs ist der Energiebandabstand 1,462 eV. Für die in der Optoelektronik verwendeten Wellenlängen von 1,3 $\mu$m bis 1,55 $\mu$m kommen somit aktive Schichten mit einem Aluminiumgehalt von x = 0,04 bis 0,3 in Frage. Dem Aluminiumgehalt x = 0,04 entspricht ein Energiebandabstand von 800 meV oder eine Wellenlänge von 1,55 μm. Dem Aluminiumanteil von x = 0,3 entspricht ein Energiebandabstand von 953 meV oder eine Wellenlänge von 1,3 μm. Damit sich an den Grenzen zu den Confinement-Schichten 2,4 ein hinreichend hoher Brechungsindexsprung ergibt, muß der Bandabstand in den Confinement-Schichten 2,4 entsprechend höher sein als in der aktiven Schicht 3. Vorteilhaft beträgt diese Differenz der Bandabstände mindestens 300 meV. Mit diesem Energiebandabstand ergibt sich für die Wellenlänge 1,55 μm oder 1,1 eV ein Aluminiumanteil x = 0,48 und für die Wellenlänge 1,3 μm oder 1,25 eV ein Aluminiumanteil x = 0,68. Als günstig für die Zusammensetzung des quaternären Materials der ConfinementSchichten 2, 4 ergibt sich daraus ein Aluminiumgehalt von mindestens 0,68 für den gesamten genutzten Wellenlängenbereich.

Es hat sich herausgestellt, daß ein gewisser Mindestgehalt an Gallium in den Confinement-Schichten 2, 4 die Morphologie deutlich verbessert. Der Gehalt an Gallium sollte mindestens 0,05 betragen. Besonders günstige Werte ergaben sich für eine Zusammensetzung der Confinement-Schichten 2, 4 aus $(Ga_{0,17}Al_{0,83})_{0,48}In_{052}As$. Ein Wert von x in der Nähe von 0,83 ist als optimal für die Confinement-Schichten 2, 4 sowohl eines Aufbaus mit einfacher aktiver Schicht wie auch mit einer Quantum-well-Struktur anzusehen. Für die Zusammensetzung der Zwischenschichten 6 bei der Quantum-well-Struktur gilt das gleiche wie für die Confinement-Schichten 2, 4; der durch x gegebene Aluminiumanteil kann aber bei den Zwischenschichten 6 etwas kleiner sein als bei den Confinement-Schichten 2, 4.

Die beschriebenen Schichtfolgen werden auf InP mittels Normaldruck-MOVPE aufgewachsen. Es wird eine horizontale, rechteckige Quarzzelle mit vertikalem Gaseinlaß eingesetzt. Die erforderlichen Epitaxietemperaturen werden mit einem Hochfrequenzgenerator erreicht. Die Substrate werden unter Arsin und Wasserstoff bis auf 500° C aufgeheizt; bei 500° C beginnt auch das Aufwachsen. Es folgt eine weitere schnelle Aufheizung bis auf 630° C - das ist die eigentliche Epitaxietemperatur, bei der bis zum Ende abgeschieden wird. Der Beginn der Epitaxie muß bei 500° C sein, denn bei dieser Temperatur verdampft der Phosphor aus dem Substrat, dessen Oberfläche wird zerstört.

### Ansprüche

1. Halbleiterlaser auf einem Substrat (1) aus InP mit einer aktiven Schicht (3) zwischen einer ersten Confinement-Schicht (2) und einer zweiten Confinement-Schicht (4), wobei das gesamte auf das Substrat (1) aufgewachsene Material keinen Phosphor als Substitutionskomponente enthält und wobei die erste Confinement-Schicht (2) und die zweite Confinement-Schicht (4) dieselbe Zusammensetzung haben,

**dadurch gekennzeichnet,**

daß die aktive Schicht (3) $(Ga_{1-x}Al_x)_{1-y}In_yAs$ mit 0,04 ≤ x 0,3 und 0,52 ≤ y ≤ 0,53 ist und

daß die erste Confinement-Schicht (2) und die zweite Confinement-Schicht (4) $(Ga_{1-x}Al_x)_{1-y}In_yAs$ mit 0,48 ≤ x ≤ 0 95 und 0,52 ≤ y ≤ 0,53 sind.

2. Halbleiterlaser nach Anspruch 1,

**dadurch gekennzeichnet,**

daß die aktive Schicht (3) eine Quantum-well-Struktur mit mindestens zwei für Strahlungserzeugung vorgesehenen QW-Schichten (5) aufweist,

daß zwischen je zwei aufeinanderfolgenden QW-Schichten (5) je eine Zwischenschicht (6) vorhanden ist,

daß die QW-Schichten (5) $(Ga_{1-x}Al_x)_{1-y}In_yAs$ sind und die Zwischenschichten (6) $(Ga_{1-x}Al_x)_{1-y}In_yAs$ mit 0,48 ≤ x ≤ 0,95 und 0,52 ≤ y ≤ 0,53 sind.

3. Halbleiterlaser nach Anspruch 2,

**dadurch gekennzeichnet,**

daß die QW-Schichten (5) $Ga_{0,47}In_{0,53}As$ sind.

4. Halbleiterlaser nach Anspruch 1, 2 oder 3,

**dadurch gekennzeichnet,**

daß die erste Confinement-Schicht (2) und die zweite Confinement-Schicht (4) $(Ga_{0,17}Al_{0,83})_{0,48}In_{0,52}As$ sind.

5. Halbleiterlaser nach Anspruch 2 oder 3,

**dadurch gekennzeichnet,**

daß die erste Confinement-Schicht (2), die zweite Confinement-Schicht (4) und jede Zwischenschicht (6) $(Ga_{0,17}Al_{0,83})_{0,48}In_{0,52}As$ sind.